# FASCICULE DE BREVET EUROPEEN

(11) **EP 3 320 403 B1**
(45) Date de publication et mention de la délivrance du brevet: **29.04.2020**
(21) Numéro de dépôt: 16734046.2
(22) Date de dépôt: 29.06.2016
(51) Int. Cl.: G04B 39/02

(54) **PROCÉDÉ DE FIXATION PAR ASSEMBLAGE ANODIQUE**
VERFAHREN ZUR FIXIERUNG DURCH ANODISCHE VERBINDUNG
METHOD FOR FIXING BY ANODIC BONDING

(30) Priorité: 06.07.2015 CH 9772015
(43) Date de publication de la demande: 16.05.2018
(73) Titulaire: Sy&Se SA, 2300 La Chaux-de-Fonds (CH)
(72) Inventeur: BRUN, Sébastien, 2057 Villiers (CH); STUER, Michael, 2000 Neuchâtel (CH)
(74) Mandataire: P&TS SA (AG, Ltd.)
(86) Numéro de dépôt international: PCT/IB2016/053871
(87) Numéro de publication internationale: WO 2017/006218

(56) Documents cités:
- WO-A2-2015/104252
- BE-A- 680 529
- CH-A3- 678 680
- JP-A- H0 580 163
- JP-A- H08 166 469

## Description

### Domaine technique

La présente invention se rapporte à un procédé d'assemblage anodique entre deux éléments avec une couche intermédiaire, notamment, mais pas exclusivement, la présente invention concerne un procédé d'assemblage anodique entre un élément métallique et un élément hétérogène, comme par exemple un verre, un cristal de synthèse, tel que par exemple un saphir, ou une céramique.

La spécificité et le but de la présente invention est de produire un assemblage étanche aux gaz et aux liquides sans soudure, sans brasure et sans composé organique (colle).

Parmi ses multiples applications industrielles, le présent procédé permet de fixer une glace de montre pouvant être typiquement en verre minéral, saphir ou autres céramiques transparentes ou translucides, à une lunette ou carrure-lunette d'une boîte de montre par la technique de l'assemblage anodique (anodic bonding). La zone de la boîte de montre sur laquelle est fixée la glace est typiquement en acier inoxydable, en platine, en or, en titane ou en un des alliages associés à ces matériaux. Les matériaux précités peuvent indifféremment être revêtus de rhodium ou toute autre matière utilisée pour la fabrication de boîtes de montres ou de produits de bijouterie ou de joaillerie. La glace peut être totalement ou en partie revêtue d'une couche antireflet, sans que cela interfère avec le procédé d'assemblage.

La présente invention permet aussi la fixation des glaces de fond. On peut également, par le procédé de l'invention, joindre des éléments d'entraînement à une lame transparente, réalisant ainsi un engrenage invisible, ou une montre mystérieuse.

### Etat de la technique

Le procédé d'assemblage anodique (anodic bonding) est utilisé dans le domaine général de la microtechnique, plus particulièrement dans les secteurs biomédicaux, aérospatiaux et en électronique. Dans ces domaines, notamment en microélectronique et les domaines voisins, les assemblages anodiques sont surtout utilisés pour les films et couches minces et plates notamment comme des wafers de métal, de verre et de silicium. Le procédé nécessitant de températures relativement élevées, il est en général utilisé pour assembler des matériaux avec des coefficients de dilatation thermique proches, afin de limiter les contraintes liés aux différences de contraction.

Dans la technique connue, l'assemblage anodique est principalement réservé au jointage du verre, notamment du verre Pyrex® ou borofloat® (verres au borosilicate).

Par le même principe de limitation des contraintes, des assemblages anodiques de petites tailles et de faible masse ou des éléments non soumis à des forces mécaniques externes, ont été décrits dans le secteur horloger dans le document JP08166469A, pour fixer une plaque de verre sur un cadran métallique ou en silicium. Le brevet JP05080163A décrit également la fixation d'index en silicium apposés sur une plaque en verre du cadran par l'assemblage anodique. Les procédés connus ne permettent toutefois pas l'assemblage de composantes massives, soumises à des contraintes mécaniques élevées, et devant résister aux chocs, notamment lorsque les pièces à joindre sont réalisés avec des matériaux hétérogènes, avec des coefficients de dilatation dissimilaires, comme c'est le cas pour l'acier inoxydable et le saphir utilisé pour réaliser les glaces de montre.

Le document BE680529 A4 divulgue des procédés d'assemblage par liaison anodique entre plusieurs substrats avec une tension électrique pulsée ou AC

CH678680 A3 divulgue un procédé d'assemblage d'une glace de montre par soudure. Ce document préconise l'utilisation d'un alliage de soudure à l'étain ou au plomb et la déposition d'une couche ou de plusieurs couches de matériau soudable tel qu'Ag, In, Bi, Au, Cu.

### Bref résumé de l'invention

Un but de la présente invention est de proposer un procédé d'assemblage exempt des limitations des procédés d'assemblage anodique connus, en particulier un procédé permettant d'obtenir des liaisons plus solides et étanches. Avantageusement, le procédé se déroule à basse température, bien inférieure aux températures de transition ou de fusion des matériaux employés.

Un autre but de la présente invention est de proposer un procédé d'assemblage anodique qui permette l'union de matériaux hétérogènes, sans être limité aux verres au borosilicate. L'assemblage décrit permet de réaliser des liaisons métal sur métal, métal sur non-métal et non métal sur non métal.

On peut par exemple assembler des éléments en acier inoxydable, titane, or, platine ou tout autre métal, des éléments de verre ordinaire, verre minéral, quartz, saphir synthétique (Al₂O₃), silicium, ou de céramique transparente ou translucide basés sur des compositions d'alumine, yttria, spinelle, ou autres compositions monocristallines, poly cristallines, ou amorphes. Les faibles températures impliquées par le procédé de l'invention permettent aussi son application à des assemblages comportant des éléments en matériaux synthétique et/ou composite.

Selon l'invention, ces buts sont atteints notamment au moyen de l'objet de la revendication 1.

Contrairement aux réalisations conventionnelles, l'assemblage proposé par la présente invention permet la liaison d'un grand nombre de matériaux par le biais de couches intermédiaires, ceci dans l'objectif de consolider le lien, augmenter la vitesse de diffusion et de permettre l'assemblage pour une plus grande gamme de matériaux et des pièces plus massives, soumises à de fortes contraintes et devant résister aux chocs.

Préférablement, la couche intermédiaire est une couche isolante ou semi-conductrice. Elle peut être une pièce rapportée (par exemple une mince lame de verre) ou, préférablement, une couche déposée par un procédé de déposition physique ou chimique (PVD, PE-CVD, Sol-gel, galvanoplastie). En alternative, la couche intermédiaire peut être une couche de passivation naturelle ou forcée, par exemple une couche d'oxyde sur un élément métallique en acier ou titane.

Les éléments de l'assemblage sont amenés en contact intime au niveau atomique par un champ électrique d'intensité suffisante. On croit, sans vouloir être limité par la théorie, que l'application d'un champ électrique permet la migration d'atomes et ions dans et de la couche intermédiaire, ainsi que la création de gradients chimiques et de charge, donnant ainsi lieu à des liens covalents et/ou ioniques entre les éléments de l'assemblage. De manière importante, le champ électrique comporte une composante variable, pulsée ou alternée, et un une composante continue. De préférence, les fréquences caractéristiques de la composante variable pulsée ou alternée sont essentiellement au-dessus de la fréquence de relaxation diélectrique des matériaux utilisés et se situent entre 0.1 et 100 kHz.

La stabilité et la force du lien anodique peuvent être améliorées considérablement en fonctionnalisant les surfaces avant l'application du champ électrique par un bombardement au plasma, notamment par des plasmas riches en oxygène.

Bien que la présente description ait présenté des exemples liés à la fabrication de montres, la présente invention admet aussi d'autres applications à l'horlogerie, et aussi à la bijouterie, à la maroquinerie, à la lunetterie, et à la production d'instruments d'écriture. L'invention n'est pas non plus limitée à la production d'éléments décoratifs, mais permet également l'assemblage d'éléments techniques composites pour des mouvements de montre, des instruments d'optique, des dispositifs médicaux, et une grande variété d'articles et produits qui utilisent du verre ou des céramiques.

### Brève description des figures

Des exemples de mise en œuvre de l'invention sont indiqués dans la description illustrée par les figures annexées dans lesquelles :
- Les figures 1a et 1b illustrent schématiquement deux dispositifs d'assemblage permettant de mettre en œuvre le procédé de l'invention.
- La figure 2 illustre des étapes du procédé inventif.
- Les figures 3a et 3b montrent des procédés de masquage sélectif.
- La figure 4 montre schématiquement et de façon simplifiée la section d'un assemblage réalisé par le procédé de l'invention et les profils de concentration certains éléments chimiques.

### Exemple(s) de mode de réalisation de l'invention

Dans un mode de réalisation qui sera décrit en détail par la suite, le procédé de l'invention est appliqué à la fixation d'une glace de montre sur une boîte ou sur une lunette de montre. Il faut toutefois comprendre que l'invention peut aussi être appliquée à l'assemblage de tout autre objet ou composant. La description sera mieux comprise avec référence à la figure la qui représente, en section, un assemblage tel que décrit dans un dispositif d'assemblage anodique.

On choisit une pièce d'une boîte de montre devant recevoir la glace, par exemple la lunette ou la carrure ; cette pièce 20 peut être fabriquée avec tous les matériaux utilisés normalement pour la réalisation de montres. On peut citer, par exemple :
- acier inoxydable,
- or, ou alliages à base d'or,
- platine,
- titane,
- céramique,
cette liste n'est pas exhaustive.

La pièce destinée à recevoir la glace peut être réalisée par n'importe quel procédé connu, par exemple par usinage, étampage, laminage, impression 3D, ou tout autre procédé. Il est important que la face en contact avec la glace soit parfaitement plane et exempt d'aspérités à l'échelle microscopique, afin de permettre un contact intime. Selon les besoins et la nature des matériaux employés cela peut être obtenu par polissage mécanique et/ou électrochimique, par exemple.

La glace 10 est réalisée par un matériau transparent idoine, par exemple :
- Saphir synthétique (Al₂O₃),
- Verre minéral,
- Quartz (SiO₂),
- Céramique transparente, par exemple :
   - comprenant des oxydes d'Yttrium (Yttralox®) ou des composés binaires Yttria/Magnesia,
   - basés sur des spinelles d'oxynitrures d'Aluminium (Alon®) ou d'oxydes de Magnésium et Aluminum,
   - autres céramiques optiques.

La surface de contact de la glace est polie chimiquement ou mécaniquement afin d'épouser parfaitement la surface correspondante de la lunette et/ou du cran de glace.

On développe ensuite une couche intermédiaire 23 sur la surface de contact de la lunette 20, et/ou de la glace 10. De préférence celle-ci est une couche mince déposée par un procédé de déposition physique ou chimique (PVD, PE-CVD, Sol-gel, galvanoplastie). Des résultats très satisfaisants ont été obtenus par des couches métalliques déposées par un procédé PVD, par exemple des couches de titane oxydé, ou par des couches d'oxydation naturelle fonctionnalisées par plasma riche en oxygène.

On a constaté que le procédé de l'invention ne requiert pas une composition chimique homogène de la couche intermédiaire 23. Bien au contraire, des couches présentant un gradient chimique et/ou d'oxydation ont fourni des résultats supérieurs en termes d'adhérence, solidité de la liaison et rapidité d'assemblage. Selon un exemple, la couche intermédiaire 23 présente une épaisseur entre 1 nm et 10 µm et sa composition varie du titane pur, dans les régions plus profondes, à l'oxyde TiO*₂* en surface, en passant par toutes les stœchiométries intermédiaires. Comme on le verra par la suite, il est avantageux accentuer ce gradient chimique avec des expositions à un plasma réactif.

Plusieurs matériaux se prêtent à la déposition de la couche intermédiaire 23. Des couches de titane, comme on dit, ont donné des excellents résultats, mais l'invention peut être répliquée avec d'autres matériaux, par exemple Zr, Hf, Fe, Si, Al, Cr, Ni, invar parmi d'autres. Le gradient chimique peut être obtenu par oxydation, nitruration, carburation, par exemple, en sorte que la composition de la couche peut être de type TiₓO_{y}, SiₓO_{y}, SiₓN_{y}, ou AlₓO_{y}. La couche intermédiaire peut être enrichie par des atomes / ions mobiles tels que Li, Na, K, Ca, Be, ou halogènes.

Lorsque le substrat est métallique, comme c'est le cas d'une lunette 20 en acier inoxydable, la couche intermédiaire 23 peut être une couche d'oxyde naturelle, se développant spontanément suite à l'exposition à l'air, ou forcée, par exposition à une atmosphère ou à un plasma réactif.

La couche intermédiaire 23 peut être obtenue, dans des variantes de l'invention, par un procédé de déposition physique en une atmosphère réactive de composition variable. On peut par exemple déposer une couche par pulvérisation cathodique, en atmosphère inerte, dans une première phase, et avec une concentration progressivement croissante de gaz réactif (typiquement oxygène) ensuite. En cette variante, la couche 23 est activée par exposition à un plasma chimiquement en même temps qu'elle est déposée. Par ce procédé on peut obtenir des couches présentant le gradient chimique souhaité.

Dans des variantes possibles, la couche intermédiaire peut être une pièce rapportée, par exemple une mince lame de verre.

La Figure la représente très schématiquement un dispositif d'assemblage permettant de réaliser le procédé inventif. La glace 10 est positionnée sur la face supérieure de la lunette 20 dans une enceinte 40. Des moyens de chauffage 45 permettent de maintenir les pièces à une température voulue. Caractéristiquement, l'invention se déroule à des températures inférieures à celles des procédés d'assemblage anodique conventionnels. La température est préférablement inférieure à 250°C. Des résultats très satisfaisants ont été obtenus à des températures de 200 °C, 150 °C, 100 °C, et même de 75 °C. En aucun cas la température ne sera proche de celle de fusion ou de transition vitreuse des matériaux employés.

La glace est connectée à une électrode 31 et la lunette est connectée à une contre électrode 32, auxquels on connecte une source de tension 30. La source tension produit un champ électrique qui engendre une migration d'ions entre la pièce 20, la couche 23 et la pièce 10.

De préférence, la tension générée par la source 30 comporte une composante continue (sa valeur moyenne ou tension DC offset) dans les limites de ce qui est généralement employé dans les procédés d'assemblage anodique, soit dans l'intervalle 0.1-15 kV, selon l'épaisseur des pièces à joindre et la rigidité diélectrique de l'assemblage. Selon l'invention, on a constaté que la qualité de l'assemblage s'améliore considérablement lorsqu'une composante AC ou pulsée est superposée à la composante continue. L'amplitude de la composante AC ou la hauteur des impulsions est de préférence comparable à celle de la composante continue, et la fréquence caractéristique sera supérieure à 100 Hz, par exemple de 1 kHz, 10 kHz, ou plus. Caractéristiquement, la fréquence caractéristique de la composante AC ou des impulsions est également de préférence supérieure aux fréquences de relaxation diélectrique des matériaux utilisés.

Si requis, les pièces 20, 10 peuvent être compressés mécaniquement. On a toutefois constaté que si les surfaces de contact sont méticuleusement polies et propres, un tel plaquage est souvent superflu. Les vitesses d'assemblage sont de l'ordre de quelques mm²/minutes.

Entre la couche intermédiaire 23 et le substrat 20 on peut déposer des couches minces avec une fonction esthétique ou physique tels que les fonctions antireflets (si le substrat 20 est transparent, par exemple), ou pour améliorer l'adhésion, ou pour tout autre but. Ces couches supplémentaires ne sont pas représentées sur les figures. La transition entre les matériaux des couches peut être discontinue ou graduelle.

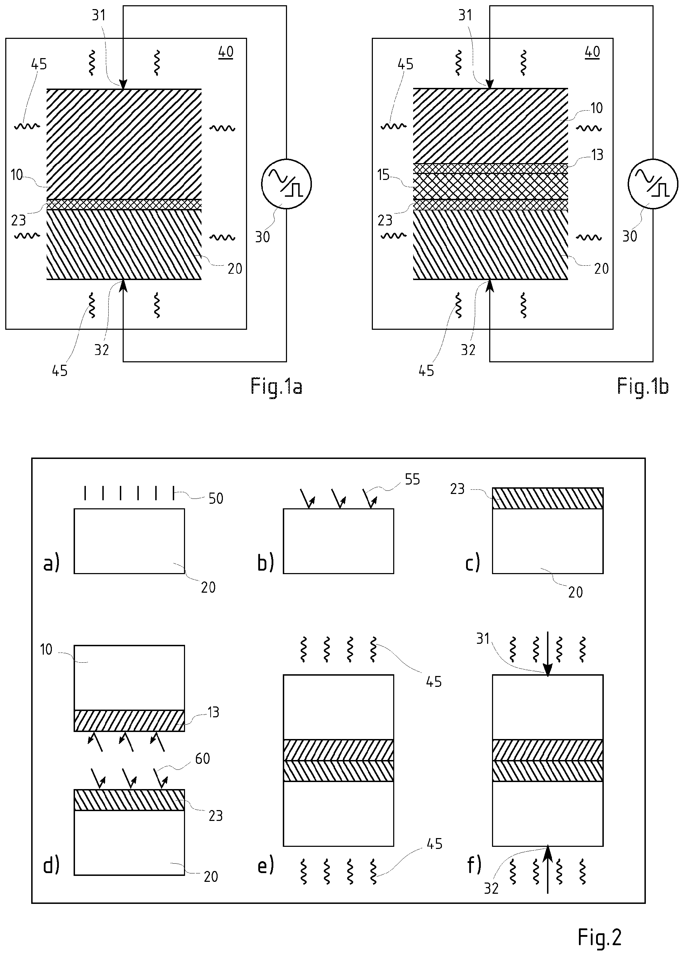

Le procédé de l'invention n'est pas limité à l'assemblage de deux éléments. La figure 1b illustre schématiquement un assemblage avec un substrat intermédiaire 15 ente le premier élément 10 et le second élément 20. Des couches intermédiaires 13, 23 sont présentes à chaque interface. Le nombre d'éléments superposés peut être augmenté à loisir.

Toute particule chargée placée sous l'influence d'un champ électrique uniforme se déplace à une vitesse proportionnelle à ce champ, le facteur de proportionnalité étant appelé la mobilité électrique de la particule. Cette migration va s'effectuer de l'anode vers la cathode pour les particules chargées positivement, dans le sens opposé pour les particules chargées négativement. Sous l'effet de la migration des ions, on observe une différence de potentiel entre les pièces 10, 20, ce qui engendre un plaquage entre les partenaires induit sous l'effet de forces électrostatiques. La perturbation de l'équilibre thermodynamique influence les populations de porteurs de charge localisés au sein des pièces à assembler et de la couche intermédiaire. Les origines des perturbations peuvent être:
- les inhomogénéités de dopage, d'impuretés, de défauts structuraux et les déformations locales (principalement au voisinage de surface), des contacts et des jonctions
- les forces de champ électrique
- les gradients de température.
- La fréquence appliquée au champ électrique

Lorsque le champ électrique ainsi que la température sont interrompues, les porteurs de charges tendent vers un état d'équilibre correspondant à des régimes permanents définis par des conditions initiales et aux bords, selon des mécanismes typiques :
- la diffusion des porteurs dans des gradients de concentration
- le déplacement des porteurs dans des champs électriques internes
- la génération et la recombinaison de porteurs qui peuvent être intrinsèques ou faire intervenir des centres de recombinaison et des pièges.

Les propriétés relatives aux courants électriques et aux déplacements de porteurs de charge sous l'influence de forces appliquées sont appelées phénomènes de transport. Parmi les phénomènes de transport, la mobilité, qu'elle soit par exemple des lacunes, des impuretés, des porteurs de charges (les matériaux sont différentiés par la longueur de Debye des porteurs majoritaires et leur comportement est notamment décrit par l'équation de continuité) ainsi que la diffusion (basée sur les lois de Fick) sont les mécanismes clés d'assemblage anodique.

Les paramètres qui influencent le plus la mobilité des porteurs de charge sont la température et le nombre volumique d'impuretés. Parmi les défauts on peut distinguer les impuretés et les lacunes. Il s'agit de ces mêmes lacunes, défauts de Schottky ou de Frenkel entre autres qui facilitent la diffusion des porteurs de charges et qui définissent l'énergie nécessaire à leur diffusion. De plus déplacer une lacune à travers un cristal demande beaucoup moins de travail que de contraindre un ion à se déplacer à travers un réseau d'ions dense d'un cristal. La conduction ionique dépend du mouvement des lacunes. Les impuretés qui contribuent à la densité de porteurs de charge sont appelées « donneurs » si elles apportent des électrons supplémentaires et « accepteurs » si elles apportent des trous supplémentaires. A noter que la vitesse du phénomène de l'assemblage anodique dépend de la quantité de défauts et de la température notamment.

Le choix de la ou des couches intermédiaires dépend fortement des "propriétés" des porteurs de charge. La composition chimique de la ou des couches est naturellement importante puisque les phénomènes de transport dépendent des caractéristiques des liaisons atomiques. Les liaisons créées lors du processus d'assemblage anodique sont des liaisons de type covalentes majoritairement. Ces liaisons fortes s'établissent par la mise en commun d'une paire d'électrons issus de chacun des porteurs de charges.

D'autres paramètres ont leurs importances telles que l'épaisseur des pièces à assembler ainsi que l'épaisseur de la zone de déplétion. Les limitations d'épaisseurs dépendent des tolérances au plan des lunettes et des glaces et sont comprises entre 1-1000 nm.

La figure 2 représente schématiquement une succession d'étape du procédé inventif. La pièce 20, usinée et polie est d'abord nettoyée (étape a) par des bains de lessivages, ou par ultrason, ou par toute procédé de lavage 50 approprié. Ensuite (étape b) on crée une couche intermédiaire d'assemblage par déposition PVD 55, comme on a discuté plus haut, ou par tout autre procédé idoine. L'étape c) représente l'élément 20 avec la couche intermédiaire 23 activée (l'élément 10 avec une autre couche intermédiaire 13 ne sont pas montrés dans l'étape c) de la figure).

La surface ou les surfaces à joindre sont préférablement activées par un bombardement de plasma réactif 60 (étape d). Les caractéristiques chimiques et physiques du plasma seront choisies en fonction de la chimie souhaitée pour la couche intermédiaire. Par exemple, des plasmas d'oxygène appliqués à des couches de titane ou d'acier ont donné des assemblages très satisfaisants en termes de solidité et rapidité. L'activation a lieu si possible, dans le même réacteur dans lequel on réalise la déposition 55.

Les surfaces activées sont sensibles à l'air, pour cette raison il est préférable compléter l'assemblage rapidement après l'étape d). Les éléments 10 et 20 sont mis en contact et chauffée (étape e), puis le champ électrique est appliqué par les électrodes 31, 32 (étape f) pour un temps déterminé, jusqu'à l'obtention du lien anodique.

Il est souvent nécessaire d'appliquer les couches intermédiaires 23, 13 sélectivement sans couvrir entièrement la surface des pièces à joindre. Il ne serait pas envisageable d'appliquer une couche de Ti/TiO₂ sur toute la surface d'une glace de montre, par exemple, car ces matériaux ne sont pas transparents. Des assemblages sélectifs sont requis par beaucoup d'autres applications.

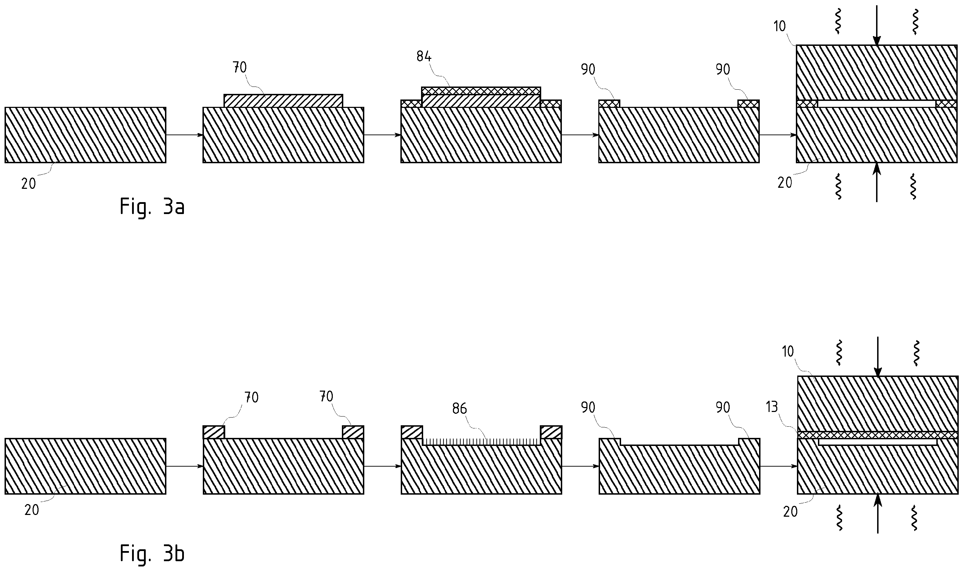

La figure 3a illustre une possibilité d'obtenir un tel assemblage. La pièce 20 est initialement couverte partiellement par un revêtement protecteur ajouré 70 qui couvre partiellement la surface, en laissant exposé seulement les régions devant être jointes. Le revêtement protecteur ou masque 70 peut être réalisé par l'application de résines photosensibles, ou par tout autre procédé approprié.

A l'étape suivante, une couche mince 84 est déposée sur l'ensemble de la pièce. Préférablement la couche 84 a aussi la fonction de couche intermédiaire pour liaison anodique. Elle peut être homogène ou comprendre plusieurs couches empilées de composition chimique hétérogène. La dissolution ou l'attaque chimique du masque 70 laisse sur la surface des régions en saille 90 qui serviront d'encrage à l'assemblage.

L'élément 10 est superposé, et l'assemblage est réalisé par application d'un champ électrique et de chaleur, comme expliqué plus haut. Préférablement le champ électrique comporte une composante continue et une composante alternée ou puisée.

La figure 3b illustre une variante du procédé de l'invention dans laquelle la sélection des régions à traiter est réalisée par un procédé d'attaque sélectif du substrat. Initialement, l'élément 20 est masqué par un revêtement protecteur 70 qui couvre uniquement les régions destinées à être jointes. Les régions non protégées subissent un attaque sélectif, par exemple par un bain chimique corrosif, un plasma, un bombardement ionique, un faisceau laser, ou tout autre moyen approprié, laissant en saille les régions 90.

La liaison est complétée par la superposition de la pièce 10 et l'application d'une tension électrique à température contrôlée, comme dans les exemples précédentes. Préférablement le champ électrique comporte une composante continue et une composante alternée ou puisée.

Dans l'exemple représenté, la couche intermédiaire 13 est déposée sur l'élément 10 et couvre toute sa surface. En un mode de réalisation alternatif, non représenté sur la figure, elle pourrait être déposée sélectivement sur la pièce 20, par exemple avant la déposition du masque 70.

### Exemple d'assemblage

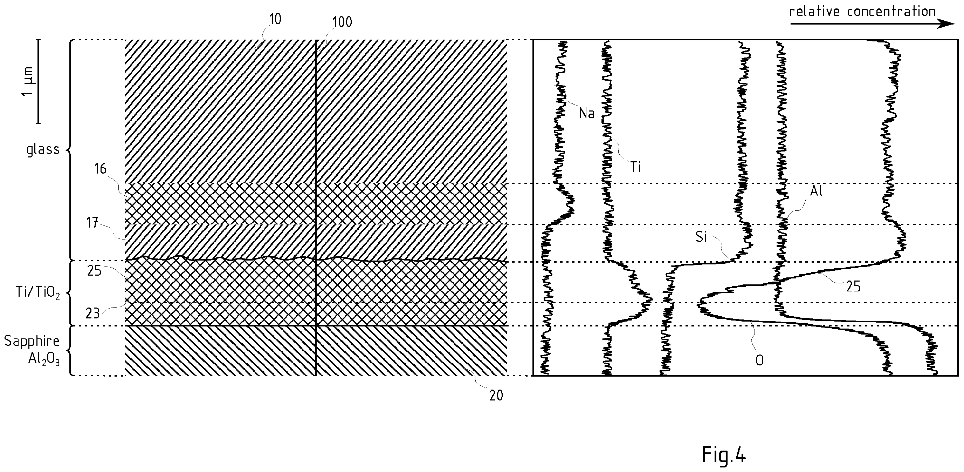

La figure 4 représente de façon simplifiée une section d'un assemblage entre un lame 10 de verre de 500 µm d'épaisseur et une lame de saphir 20. Préalablement à l'assemblage, une couche intermédiaire de titane 23 a été déposée par un procédé de pulvérisation cathodique sur le saphir, pour une épaisseur total d'un micromètre environ.

La déposition de la couche intermédiaire 23 a eu lieu d'abord en atmosphère inerte (par exemple argon), et en présence d'une concentration progressivement croissante d'oxygène ensuite. La composition chimique de la couche intermédiaire change avec continuité du titane pur à l'oxyde de Titane TiO₂ (région 25), en passant par toutes les stœchiométries intermédiaires.

L'assemblage a été ensuite obtenu par l'application d'un champ électrique comprenant une composante continue -2.4 kV (polarité de l'électrode appliquée à la lame de verre 10) superposée à une composante pulsée en onde carrée de 1.2 kV à 1 kHz pour 12.5 minutes à 200°C.

La figure 4 a été obtenue à partir d'une analyse SEM-EDX (Scanning Electron Microscope-Energy Dispersive X-ray analysis) d'une tranche de l'assemblage. Cette technique permet d'obtenir des informations sur la nature chimique des couches analysées. Le cadre sur la droite de la figure 4 montre les profils de concentration de différentes espèces atomiques. Il est à noter que les diagrammes de concentration ne sont pas tous à la même échelle, et ont été décalés pour améliorer la lisibilité.

Les diagrammes montrent clairement la présence d'un gradient chimique d'oxydation à l'intérieur de la couche intermédiaire 23 et une zone riche en sodium, due à la migration des ions Na dans le verre sous l'effet du champ électrique, ce qui est caractéristique des liaisons anodiques.

### Numéros de référence employés sur les figures

- 10: premier élément
- 13: couche intermédiaire du premier élément
- 15: substrat intermédiaire
- 16: couche enrichie en sodium
- 17: couche appauvrie en sodium
- 20: deuxième élément
- 23: couche intermédiaire du deuxième élément
- 25: gradient d'oxydation
- 30: source de tension
- 31: électrode
- 32: électrode
- 40: enceinte
- 45: chauffage
- 50: lavage
- 55: déposition
- 60: activation de surface
- 70: masque
- 84: déposition
- 86: ablation
- 90: site active
- 100: ligne de scansion

## Revendications

1. Procédé d'assemblage par liaison anodique entre un premier substrat et un second substrat comprenant :
• interposition d'une couche intermédiaire entre le premier et le second substrat;
• assemblage des substrats à une température d'assemblage déterminée;
• Application d'une tension électrique entre le premier et le second substrat. ,
**caractérisé en ce que** ladite tension électrique comporte une composante pulsée ou AC, et **en ce que** ladite température d'assemblage est inférieure à 300 °C, préférablement non supérieure à 200 °C.

2. Procédé d'assemblage selon la revendication précédente, dans lequel la ladite tension électrique comporte une composante DC.

3. Procédé d'assemblage selon la revendication précédente, dans lequel ladite composante pulsée ou AC a une fréquence supérieure à 50 Hz, préférablement supérieure à 100 Hz.

4. Procédé d'assemblage selon l'une des revendications précédentes dans lequel ladite couche intermédiaire est une couche en verre.

5. Procédé d'assemblage selon la revendication précédente, dans lequel la couche intermédiaire présente un gradient chimique et/ou un gradient d'oxydation.

6. Procédé d'assemblage selon l'une des revendications de 1 à 2, dans lequel ladite couche intermédiaire est une couche d'oxyde de titane.

7. Procédé d'assemblage selon la revendication précédente, comprenant une étape de déposition d'une couche mince oxydable sur un des substrats, suivie d'une étape d'oxydation.

8. Procédé d'assemblage selon l'une des revendications précédentes, comprenant une étape de fonctionnalisation de ladite couche intermédiaire par un plasma réactif, par exemple un plasma riche en oxygène.

9. Procédé d'assemblage selon l'une des revendications précédentes, dans lequel ledit premier substrat est métallique, par exemple un substrat en acier, acier inoxydable, titane, or, aluminium, platine ou en un des alliages associés à ces matériaux et ledit second substrat est une céramique, ou un verre, ou un matériau isolant cristallin, notamment un saphir synthétique.

## Patentansprüche

1. Verfahren zum Zusammenfügen durch anodisches Bonden zwischen einem ersten Substrat und einem zweiten Substrat, umfassend
• Einfügen einer Zwischenschicht zwischen dem ersten und dem zweiten Substrat;
• Zusammenfügen der Substrate bei einer bestimmten Fügetemperatur;
• Anlegen einer elektrischen Spannung zwischen dem ersten und dem zweiten Substrat,
**dadurch gekennzeichnet, dass** die elektrische Spannung eine gepulste oder AC-Komponente aufweist und dadurch, dass die Fügetemperatur niedriger als 300 °C ist, wobei sie vorzugsweise 200 °C nicht übersteigt.

2. Verfahren zum Zusammenfügen nach dem vorhergehenden Anspruch, wobei die elektrische Spannung eine DC-Komponente aufweist.

3. Verfahren zum Zusammenfügen nach dem vorhergehenden Anspruch, wobei die gepulste oder AC-Komponente eine Frequenz hat, die höher als 50 Hz, vorzugsweise höher als 100 Hz, ist.

4. Verfahren zum Zusammenfügen nach einem der vorhergehenden Ansprüche, wobei es sich bei der Zwischenschicht um eine Glasschicht handelt.

5. Verfahren zum Zusammenfügen nach dem vorhergehenden Anspruch, wobei die Zwischenschicht einen chemischen Gradienten und/oder einen Oxidationsgradienten aufweist.

6. Verfahren zum Zusammenfügen nach einem der Ansprüche 1 bis 2, wobei es sich bei der Zwischenschicht um eine Titanoxidschicht handelt.

7. Verfahren zum Zusammenfügen nach dem vorhergehenden Anspruch, wobei es einen Schritt des Abscheidens einer oxidierbaren Dünnschicht auf einem der Substrate, gefolgt von einem Oxidationsschritt, umfasst.

8. Verfahren zum Zusammenfügen nach einem der vorhergehenden Ansprüche, wobei es einen Schritt des Funktionalisierens der Zwischenschicht durch ein reaktionsfähiges Plasma, beispielsweise ein sauerstoffreiches Plasma, umfasst.

9. Verfahren zum Zusammenfügen nach einem der vorhergehenden Ansprüche, wobei es sich bei dem ersten Substrat um ein metallisches handelt, beispielsweise um ein Substrat aus Stahl, nichtrostendem Stahl, Titan, Gold, Aluminium, Platin oder aus einer der Legierungen in Verbindung mit diesen Materialien, und es sich bei dem zweiten Substrat um einen keramischen Stoff oder um ein Glas oder um ein kristallines isolierendes Material handelt, insbesondere um einen synthetischen Saphir.

## Claims

1. An anodic bonding method between a first substrate and a second substrate comprising:
• interposing an intermediate layer between the first and second substrates;
• assembly of the substrates at a determined bonding temperature;
• application of an electric voltage between the first and the second substrate,
**characterised in that** said electric voltage comprises a pulsed or AC component, and **in that** said bonding temperature is less than 300 °C, preferably not more than 200 °C.

2. An anodic bonding method according to the previous claim, wherein said electric voltage comprises a DC component.

3. An anodic bonding method according to the previous claim, wherein said pulsed or AC component has a frequency greater than 50 Hz, preferably greater than 100 Hz.

4. An anodic bonding method according to one of the previous claims wherein said intermediate level is a glass layer.

5. An anodic bonding method according to the previous claim, wherein the intermediate layer exhibits a chemical gradient and/or an oxidation gradient.

6. An anodic bonding method according to claims 1 to 2, wherein said intermediate layer is a titanium oxide layer.

7. An anodic bonding method according to the previous claim, comprising a step of deposition of a thin oxidisable layer on one of the substrates, followed by an oxidation step.

8. An anodic bonding method according to one of the previous claims, comprising a step of functionalizing of said intermediate layer with a reactive plasma, for example a plasma rich in oxygen.

9. An anodic bonding method according to one of the previous claims, wherein said first substrate is metallic, for example a substrate in steel, stainless steel, titanium, gold, aluminium, platinum or in one of the alloys associated with these materials and said second substrate is a ceramic, or a glass, or a crystalline insulating material, in particular a synthetic sapphire.
